# EUROPEAN PATENT APPLICATION

(11) **EP 2 408 276 A1**
(43) Date of publication of application: **18.01.2012**
(21) Application number: 10750875.6
(22) Date of filing: 10.03.2010
(51) Int. Cl.: H05H 1/46, C23C 16/505, H01L 21/205, H01L 21/3065

(54) **PLASMA PROCESSING APPARATUS**

(30) Priority: 11.03.2009 JP 2009057328
(71) Applicant: EMD Corporation, Kyoto 601-8355 (JP)
(72) Inventor: SETSUHARA, Yuichi, Suita-shi Osaka 565-0871 (JP); EBE, Akinori, Kyoto-shi Kyoto 601-8355 (JP)
(74) Representative: Ludewigt, Christoph
(86) International application number: PCT/JP2010/054019
(87) International publication number: WO 2010/104122

(57) **Abstract**

The present invention provides a plasma processing device capable of inducing a strong radio-frequency electric field within a vacuum container while preventing sputtering of the antenna conductor, an increase in the temperature of the antenna conductor and the formation of particles. A plasma processing device 10 according to the present invention includes a vacuum containem11, a radio-frequency antenna 21 placed between an inner surface 111A and an outer surface 111B of a wall of the vacuum container 11, and a dielectric separating member 16 for separating the radio-frequency antenna 21 from an internal space of the vacuum container 11. As compared to a device using an external antenna, the present device can induce a stronger magnetic field in the vacuum container 11. The separating member 16 has the effects of preventing the radio-frequency antenna 21 from undergoing sputtering by the plasma produced in the vacuum container 11, suppressing an increase in the temperature of the radio-frequency antenna 21, and preventing the formation of particles.

## Description

### TECHNICAL FIELD

The present invention relates to an inductively coupled plasma processing device that can be used for the surface processing of a base body or for other purposes.

### BACKGROUND ART

Inductively coupled plasma processing devices are widely used for the thin-film formation on or the etching process of the surface of a base body. In inductively coupled plasma processing devices, a plasma production gas, such as hydrogen gas, is introduced into a vacuum container, after which a radio-frequency electric field is induced to decompose the plasma production gas and thereby produce plasma. Subsequently, another kind of gas, which serves as a film-forming material gas or an etching gas, is introduced into the vacuum container. In the former case, the molecules of the film-forming material gas are decomposed by the plasma and deposited on a base body. In the latter case, the molecules of the etching gas are decomposed into ions or radicals for the etching process.

Patent Document 1 discloses a plasma processing device using an external antenna, in which a radio-frequency antenna for inducing a radio-frequency electric field is disposed above the ceiling of the vacuum container and the portion of the ceiling located directly below the radio-frequency antenna is made of a dielectric material serving as a window for allowing the passage of the induced radio-frequency electric field. In this external antenna type plasma processing device, when the device size is increased to deal with the recent increase in the size of the base body to be processed, it is necessary to increase the thickness of the dielectric window in order to maintain its mechanical strength, which results in a decrease in the strength of the radio-frequency electric field introduced into the vacuum container. Given this problem, an internal antenna type plasma processing device, in which the radio-frequency antenna is provided inside the vacuum container, has also been conventionally used (see Patent Documents 2 and 3).

The invention described in Patent Document 3 uses a radio-frequency antenna consisting of a one-dimensional conductor that is terminated without completing one turn (which corresponds to an inductively coupled antenna with the number of turns less than one), such as a U-shaped or semicircular antenna. Such a radio-frequency antenna has an inductance lower than that of an inductively coupled antenna whose number of turns is equal to or greater than one. The lower inductance reduces the radio-frequency voltage occurring at both ends of the radio-frequency antenna and thereby suppresses radio-frequency fluctuation of the plasma potential due to electrostatic coupling to the generated plasma. As a result, an excessive loss of electrons to the ground potential due to the fluctuation of the plasma potential is decreased, whereby the plasma potential is decreased. Therefore, a film formation process with a low level of ion damage to the base body can be performed.

### BACKGROUND ART DOCUMENT

### PATENT DOCUMENT

Patent Document 1: JP-A 8-227878 (Paragraph [0010] and Fig. 5)
Patent Document 2: JP-A 11-317299 (Paragraphs [0044]-[0046] and Figs. 1-2)
Patent Document 3: JP-A 2001-035697 (Paragraphs [0050]-[0051] and Fig. 11)

### DISCLOSURE OF THE INVENTION

### PROBLEM TO BE SOLVED BY THE INVENTION

In the internal antenna type plasma processing device, the ions in the plasma are accelerated toward the radio-frequency antenna by a self-bias DC voltage which occurs between the conductor of the radio-frequency antenna and the plasma. Therefore, the conductor of the radio-frequency antenna itself undergoes sputtering, which shortens the life of the conductor. Furthermore, the atoms or ions sputtered from the conductor are mixed in the plasma and adhere to the surface of the base body being processed or the inner wall of the vacuum container, causing impurities to be mixed in the thin film being formed or the base body being etched. Another problem of the internal antenna type is that the temperature of the radio-frequency antenna conductor increases since the radio-frequency antenna conductor is located within the plasma. A change in the temperature of the radio-frequency antenna changes the impedance of the radio-frequency antenna, which prevents stable supply of power to the plasma. To address these problems, in the invention described in Patent Document 2, the radio-frequency antenna is sheathed in a pipe made of a dielectric (insulating) material, such as ceramic or quartz, which is less likely to be sputtered than the material of the radio-frequency antenna conductor, such as copper or aluminum, and cooling water is passed through this dielectric pipe. However, this configuration requires both an electrical connector for inputting a radio-frequency power and a connector for supplying or discharging the cooling water to be provided at the ends of the antenna conductor and the dielectric pipe. Such a structure will be complex, making it difficult to attach or detach the antenna or perform maintenance and inspection thereof.

In the internal antenna type, since the radio-frequency antenna protrudes into the internal space of the vacuum container, the plasma is produced in the vicinity of the radio-frequency antenna. Therefore, the plasma density particularly increases in the vicinity of the radio-frequency antenna and the density distribution becomes less uniform. Furthermore, since the radio-frequency antenna is located within the vacuum container, the material of the thin film used in the film formation process or a by-product resulting from the etching process may possibly adhere to the surface of the radio-frequency antenna (or a dielectric pipe around this antenna). Such a material or by-product may fall onto the surface of the base body and form so-called particles.

Furthermore, as compared to the external antenna type, the internal antenna type needs a vacuum container having a larger capacity in order to ensure a space for the radio-frequency antenna within the vacuum container. Therefore, the gas or plasma easily diffuses, which decreases the amount of ions or radicals reaching the base body and lowers the film-formation rate or etching rate.

The problem to be solved by the present invention is to provide a plasma processing device capable of inducing a strong radio-frequency electric field within a vacuum container while preventing sputtering of the antenna conductor, an increase in the temperature of the antenna conductor and the formation of particles.

### MEANS FOR SOLVING THE PROBLEMS

A plasma processing device according to the present invention aimed at solving the aforementioned problem includes:
a) a vacuum container;
b) an antenna-placing section provided between an inner surface and an outer surface of a wall of the vacuum container;
c) a radio-frequency antenna placed in the antenna-placing section; and
d) a dielectric separating member for separating the antenna-placing section from an internal space of the vacuum container.

In the plasma processing device according to the present invention, the radio-frequency antenna is placed in the antenna-placing section provided between the inner and outer surfaces of a wall of the vacuum container. Therefore, a stronger radio-frequency electric field can be induced within the vacuum container as compared to the external antenna type.

Since the radio-frequency antenna is separated from the internal space of the vacuum container by a dielectric separating member, the formation of particles and the sputtering of the radio-frequency antenna are prevented. Simultaneously, an increase in the temperature of the radio-frequency antenna is suppressed.

Since it is unnecessary to provide a space for placing the radio-frequency antenna within the vacuum container, the capacity of the vacuum container can be smaller than in the case of the internal antenna type. Therefore, the diffusion of the gas or plasma is suppressed, which increases the amount of ions or radicals reaching the base body and improves the film-formation rate or the etching rate.

The separating member may be a dielectric member provided apart from the wall of the vacuum container. Alternatively, if the wall of the vacuum container is made of a dielectric material, a portion of the wall may be used as the separating member.

Although the radio-frequency antenna may be embedded in the wall, it is easier to place it in a hollow space formed between the aforementioned inner and outer surfaces. In the former case, the portion of the wall of the vacuum container in which the radio-frequency antenna is embedded corresponds to the antenna-placing section. In the latter case, the hollow space corresponds to the antenna-placing section.

The hollow space may be a hermetically closed space. This design prevents foreign matters from entering the hollow space. When this hollow space is in the vacuum state or filled with an inert gas, no unnecessary electric discharge occurs in the hollow space.

The hollow space may be filled with a solid dielectric material. This also prevents the occurrence of unnecessary electric discharge in the hollow space. In this case, it is unnecessary to hermetically close the hollow space. Instead of using the hollow space, it is possible to adopt the structure in which at least a portion of the wall is made of a solid dielectric and the radio-frequency antenna is embedded in the solid dielectric.

A cover may be provided on the outer-surface side of the hollow space. The use of such a cover facilitates maintenance, inspection or similar tasks; when the cover is opened, the radio-frequency antenna can be easily removed from the hollow space through the wall of the vacuum container to the outside and then set to the original position. Furthermore, the radio-frequency antenna may be fixed to the cover. In this case, users can more easily remove or set the radio-frequency antenna by merely detaching or attaching the cover.

The plasma processing device according to the present invention may be provided with a plurality of antenna-placing sections. This design further improves the uniformity in the density of the plasma created within the vacuum container.

### EFFECT OF THE INVENTION

The plasma processing device according to the present invention is capable of inducing a strong radio-frequency electric field within a vacuum container while preventing sputtering of the antenna conductor, an increase in the temperature of the antenna conductor and the formation of particles.

### BRIEF DESCRIPTION OF THE DRAWINGS

Fig. 1 is (a) a vertical sectional view of the first embodiment of the plasma processing device according to the present invention and (b) a vertical sectional view of a radio-frequency antenna unit 20 used in this plasma processing device.
Fig. 2 is (a) a perspective view, (b) top view and (c) side view showing the shape of a radio-frequency antenna 21 used in the plasma processing device of the present embodiment.
Fig. 3 is a top view showing one example of the connection between radio-frequency antennae and radio-frequency power sources.
Fig. 4 is an enlarged vertical sectional view showing a first variation of the first embodiment.
Fig. 5 is an enlarged vertical sectional view showing a second variation of the first embodiment.
Fig. 6 is an enlarged vertical sectional view of the second embodiment of the plasma processing device according to the present invention.
Fig. 7 is an enlarged vertical sectional view of the third embodiment of the plasma processing device according to the present invention.
Fig. 8 is an enlarged vertical sectional view of the fourth embodiment of the plasma processing device according to the present invention.
Fig. 9 is (a) an enlarged vertical sectional view of the fifth embodiment of the plasma processing device according to the present invention, and (b) a top view of the radio-frequency antenna 41 used in this embodiment.
Fig. 10 is an enlarged vertical sectional view of the sixth embodiment of the plasma processing device according to the present invention.
Fig. 11 is (a) an enlarged vertical sectional view of the seventh embodiment of the plasma processing device according to the present invention, and (b) a top view showing the construction of a Faraday electrode 51 and surrounding components.

### BEST MODE FOR CARRYING OUT THE INVENTION

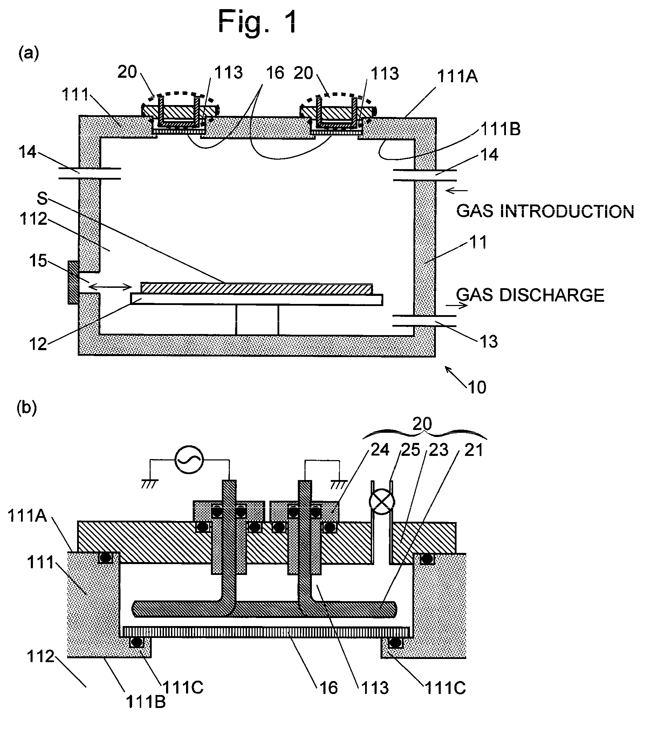

Embodiments of the plasma processing device according to the present invention are hereinafter described by means of Figs. 1-11.

### FIRST EMBODIMENT

Fig. 1(a) is a vertical sectional view of a plasma processing device 10 of the first embodiment. This plasma processing device 10 includes a vacuum container 11, a base-body holder 12 placed in the internal space 112 of the vacuum container, a gas discharge port 13 and gas introduction ports 14 provided in the side wall of the vacuum container 11, hollow spaces (antenna-placing sections) 113 provided between the outer surface 111A and the inner surface 111B of the top wall 111 of the vacuum container 11, a separating member (separating plate) 16 for separating the hollow space 113 from the internal space 112 of the vacuum container, and a radio-frequency antenna unit 20 attached to the hollow space 113 from the side of the outer surface 111A.

The separating member 16 is made of a dielectric material. Examples of the available materials include oxides, nitrides, carbides and fluorides. Among these materials, quartz, alumina, zirconia, yttria, silicon nitride or silicon carbide can be suitably used.

A step 111C protruding inwards is formed at the lower end of the inner circumferential surface of the hollow space 113. The separating plate 16 is fixed to this step 111C in such a manner that its outer circumferential edge is mounted on the step 111C. The cover 23 has a projecting portion on its lower surface so that it can fit in the hollow space 113 from the outside of the vacuum container 11.

The gas discharge port 13 is connected to a vacuum pump. By this vacuum pump, the air, steam and other contents in the internal space 112 of the vacuum container are discharged through the gas discharge port 13 to create a high vacuum state. The gas introduction port 14 is used for introducing a plasma production gas (e.g. hydrogen gas) and a film-forming material gas into the internal space 112 of the vacuum container. The base body S to be held on the base-body holder 12 is loaded into the internal space 112 of the vacuum container or unloaded from the same space through a base-body transfer opening 15 formed in the side wall of the vacuum container 11. The base-body transfer opening 15 is hermetically closed except when the base body is loaded into or unloaded from the vacuum container.

The radio-frequency antenna unit 20 is hereinafter described. Fig. 1(b) is a vertical sectional view showing the hollow space 113 and surrounding components, including the radio-frequency antenna unit 20. The radio-frequency antenna unit 20 consists of a cover 23 and a radio-frequency antenna 21, the cover 23 being made of a metal (e.g. stainless steel) closing the hollow space 113 from the outside of the vacuum container 11.

The radio-frequency antenna 21 is placed within the hollow space 113, with both ends fixed to the cover 23 via feedthroughs 24. Since the radio-frequency antenna 21 is fixed to the cover 23 in this manner, the radio-frequency antenna 21 can be easily detached from or attached to the plasma processing device by detaching or attaching the cover 23. The radio-frequency antenna 21 consists of an electrically conductive pipe, through which a cooling water or similar coolant can be passed. One end of the radio-frequency antenna 21 is connected to the radio-frequency power source, while the other end is connected to a ground.

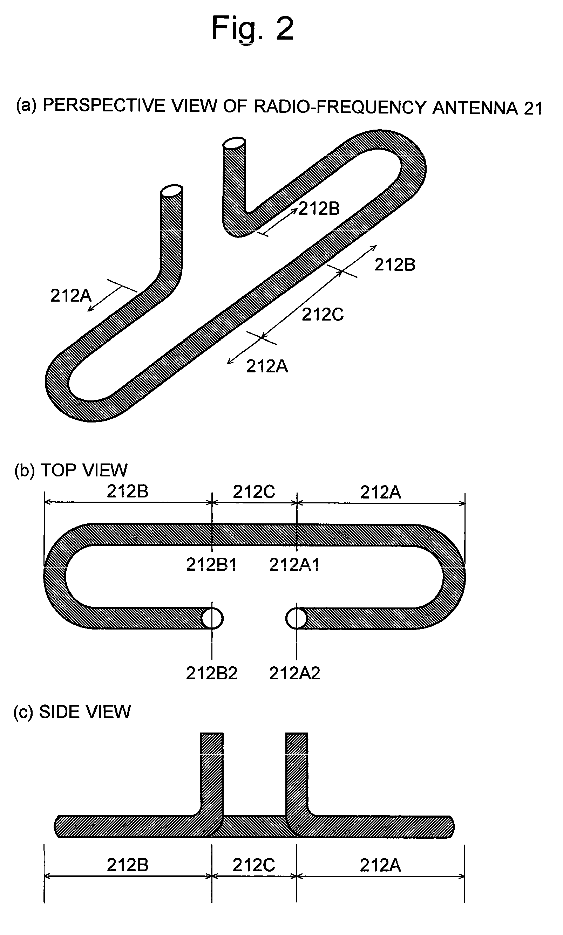

The shape of the radio-frequency antenna 21 is hereinafter described. As shown in Fig. 2, the radio-frequency antenna 21 includes a first U-shape part 212A and a second U-shape part 212B consisting of two U-shaped pipes arranged parallel to the separating member 16, with each pipe having its two ends directed to those of the other pipe. One end 212A1 of the first U-shape part 212A is connected to one end 212B 1 of the second U-shape part 212B by a straight connection part 212C. The other ends 212A2 and 212B2 of the first and second U-shape parts 212A and 212B are bent upward and connected to the cover 23.

The cover 23 is provided with a hollow-space exhaust port 25 for evacuating the hollow space 113. The gaps between the radio-frequency antenna 21 and the feedthrough 24, between the feedthrough 24 and the cover 23, between the cover and the top wall 111, and between the separating member 16 and the top wall 111 are hermetically sealed by vacuum seals. The hollow space 113 is maintained in a high vacuum state by the hollow-space exhaust port 25 and the vacuum seals.

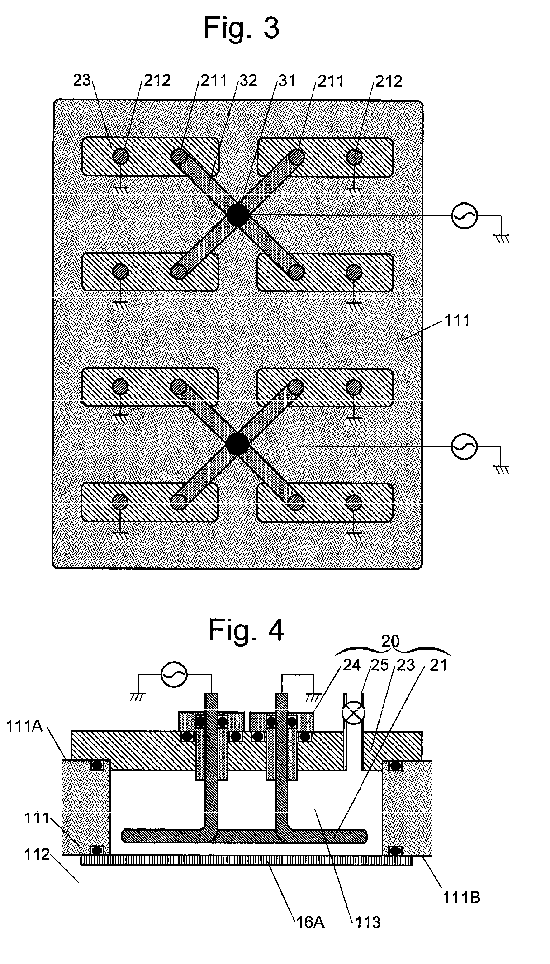

One example of the connection between the radio-frequency antennae 13 and radio-frequency power sources is hereinafter described by means of Fig. 3. Fig. 3 is a top view of the plasma processing device 10 of the present embodiment. The device of the present embodiment uses a total of eight radio-frequency antennae 21 contained in eight hollow spaces 113, respectively. These eight radio-frequency antennae 21 are divided into two groups, each group including four antennae, and one radio-frequency power source is connected to each group. A power supply end 211 of each of the radio-frequency antennae 21 is connected to each of the four power supply rods 32 extending from a power supply point 31 in four directions. The aforementioned radio-frequency power source is connected to that point 31.

As one example of the operation of the plasma processing device 10 of the present embodiment, the process of depositing a film-forming material on the base body S is hereinafter described. Initially, a base body S is loaded through the base-body transfer opening 15 into the internal space 112 of the vacuum container and placed onto the base-body holder 12. After the base-body transfer opening 15 is closed, the vacuum pump is energized, whereby the air, steam and other contents in the internal space 112 of the vacuum container are discharged through the gas discharge port 13, and the air, steam and other contents in the hollow space 113 are also discharged through the hollow-space exhaust port 25. Thus, the internal space 112 of the vacuum container and the hollow space 113 are evacuated. Subsequently, a plasma production gas and a film-forming material gas are introduced from the gas introduction port 14. A radio-frequency power is supplied to each radio-frequency antenna 21, while a coolant is passed through the pipe of the radio-frequency antenna 21. By this radio-frequency power supply, a radio-frequency electric field is induced around the radio-frequency antenna 21. This radio-frequency electric field is introduced through the dielectric separating member 16 into the internal space 112 of the vacuum container and ionizes the plasma production gas, whereby plasma is produced. The film-forming material gas, which has been introduced into the internal space 112 of the vacuum container together with the plasma production gas, is decomposed by the resultant plasma, to be deposited on the base body S.

As compared to the external antenna type, the plasma processing device 10 of the present embodiment can create a stronger radio-frequency electric field within the internal space 112 of the vacuum container 11 since the radio-frequency antenna 21 is located in the hollow space 113 provided between the outer surface 111A and the inner surface 111B of the top wall 111 of the vacuum container. The separation of the hollow space 113 including the radio-frequency antenna 21 from the internal space 112 of the vacuum container by the separating member 16 has the effects of: preventing plasma produced in the aforementioned space from etching the radio-frequency antenna 21 and shortening its life; preventing the material of the radio-frequency antenna 21 from becoming an impurity to be mixed in the film being formed or the base body being processed; and preventing the formation of particles. Furthermore, since the hollow space 113 in which the radio-frequency antenna 21 is placed is maintained in a high vacuum state, no unnecessary electric discharge occurs in the hollow space 113.

In the present embodiment, a magnetic field created in the first U-shape part 212A of the radio-frequency antenna 21 by an electric current flowing from one end 212A1 to the bottom part of the U-shaped body, and a magnetic field created by an electric current flowing from the bottom part of the U-shaped body to the other end 212A2, have vertical components oscillating in the same phase. Magnetic fields having such vertical components are similarly created in the second U-shape part 212B. As a result, the magnitude of the vertical component of the magnetic field below the antenna will be greater than in the case of using a single straight radio-frequency antenna. Therefore, as compared to the case of using a single straight radio-frequency antenna, a higher plasma density can be achieved under the same strength of the radio-frequency power and/or the same pressure of the plasma production gas, or the same plasma density can be achieved under a lower strength of the radio-frequency power and/or a lower pressure of the plasma production gas.

A first variation of the first embodiment is hereinafter described by means of Fig. 4. In the present variation, the top wall 111 has no step 111C; the separating member 16A is arranged so that it covers the hollow space 113 on the side facing the internal space 112 of the vacuum container. With this design, the hollow space 113 is expanded toward the internal space 112 of the vacuum container and the radio-frequency antenna 21 can be brought closer to the internal space 112 of the vacuum container. The other structural elements are the same as those of the previously described embodiment.

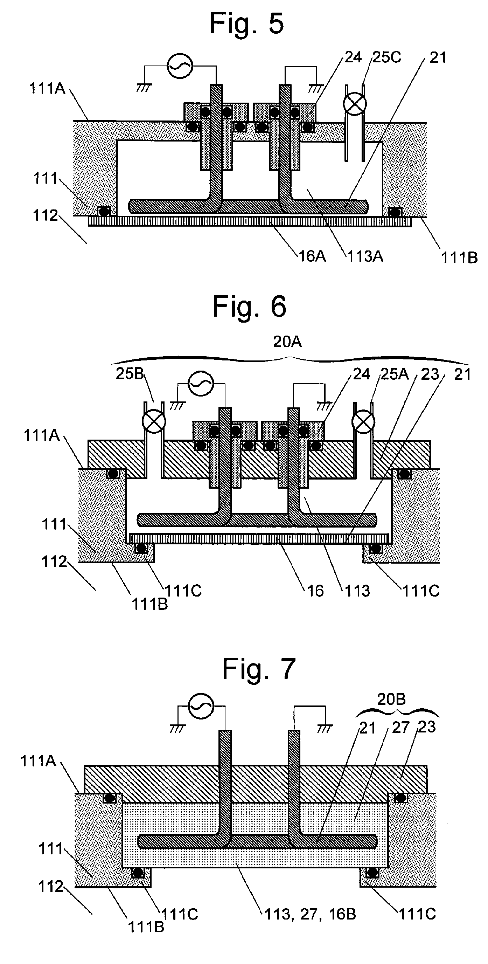

A second variation of the first embodiment is hereinafter described by means of Fig. 5. In the present variation, a hollow space 113A is created by boring a hole from the lower surface of the top wall 111 without completely penetrating through the top wall 111. Accordingly, a portion of the top wall 111 remains intact above the hollow space 113A. The radio-frequency antenna 21 is fixed to this remaining portion of the top wall 111 via feedthroughs. The hollow-space exhaust port 25C is also provided in that portion of the top wall 111. The structure of the separating member 16A is the same as that of the first variation.

### SECOND EMBODIMENT

A plasma processing device of the second embodiment is hereinafter described by means of Fig. 6. In the present embodiment, a hollow-space inert-gas introduction port 25A and a hollow-space gas discharge port 25B are provided in the cover 23 of the radio-frequency antenna unit 20A in place of the hollow-space exhaust port 25 in the first embodiment. The hollow space 113 can be filled with an inert gas, such as argon or nitrogen, by introducing the inert gas through the hollow-space inert-gas introduction port 25A to replace air and steam in the hollow space 113 by the inert gas and discharge the air and steam through the hollow-space gas discharge port 25B to the outside. As a result, similar to the case of evacuating the hollow space 113, the occurrence of unnecessary electric discharge is prevented. The other structural elements are the same as those of the first embodiment.

### THIRD EMBODIMENT

A plasma processing device of the third embodiment is hereinafter described by means of Fig. 7. In the present embodiment, the hollow space 113 is filled with a dielectric member 27. Examples of the materials for the dielectric member 27 include polytetrafluoroethylene (PTFE), polyether ether ketone (PEEK) and other resins as well as alumina, silica and other ceramics. The bottom portion of the dielectric member 27 functions as the separating member. The radio-frequency antenna 21, which is U-shaped similar to the previous embodiment, is directly fixed to the cover 23 without using feedthroughs. Since the radio-frequency antenna 21 is fixed to the cover 23 in this manner, both the radio-frequency antenna 21 and the dielectric member 27 around this antenna 21 are attached to or detached from the vacuum container 11 when the cover 23 is attached to or detached from this container 11. Accordingly, it can be said that the radio-frequency antenna 21, the cover 23 and the dielectric member 27 in the present embodiment form one set of the radio-frequency antenna unit 20B.
In the third embodiment, since the hollow space 113 is filled with the dielectric member 27, no unnecessary electric discharge occurs in the vicinity of the radio-frequency antenna 21.

In place of the dielectric member 27, a dielectric powder may be filled into the hollow space 113. In this case, the hollow space 113 should be hermetically closed so that the powder will not leak from the hollow space 113.

### FOURTH EMBODIMENT

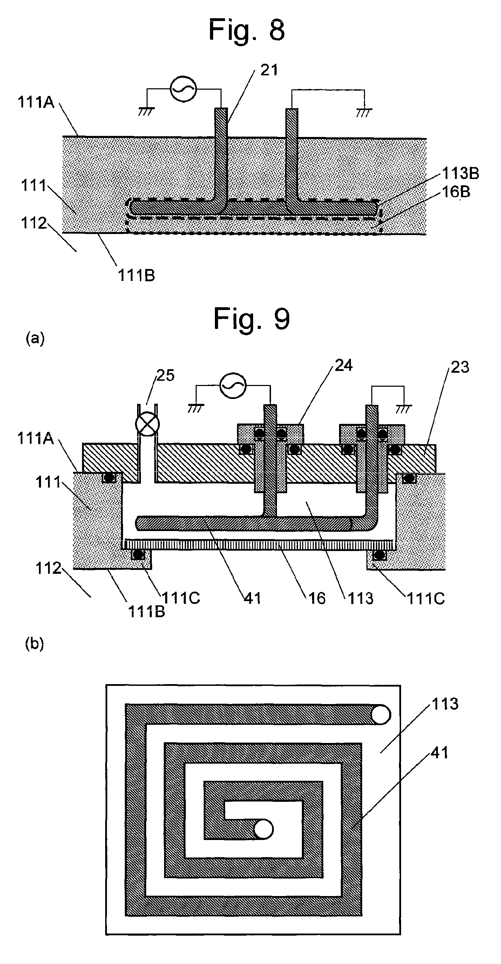

In any of the previous examples, the radio-frequency antenna 21 was provided within the hollow space 113. However, it is possible to embed the radio-frequency antenna 21 between the outer surface 111A and the inner surface 111B without using any hollow space, as shown in Fig. 8, where the region denoted by numeral 113B corresponds to the antenna-placing section. In this case, in order to electrically insulate the radio-frequency antenna 21 from the top wall 111 and to prevent unnecessary electric discharge from occurring in the vicinity of the radio-frequency antenna 21, a dielectric member should be provided between the radio-frequency antenna 21 and the top wall 111, or the top wall 111 should be made of a dielectric material. In the latter case, the top wall 111 may be entirely made of the dielectric material. However, for the sake of the cost reduction, it is preferable to use the dielectric material only in the portion of the top wall 111 near the radio-frequency antenna 21. For the herein mentioned dielectric material, the previously listed materials of the dielectric member 27 are similarly available. The portion of the top wall 111 located between the radio-frequency antenna 21 and the internal space 112 of the vacuum container may be made of a dielectric material so that this portion functions as a separating plate 16B.

### FIFTH EMBODIMENT

One example using a radio-frequency antenna having a shape different from any of the previous embodiments is described by means of Fig. 9. As shown in Fig. 9(b), the radio-frequency antenna 41 in the present embodiment consists of one electrically conductive pipe spirally wound in a plane parallel to the separating member 16. The other structural elements are the same as those of the first embodiment. By using the radio-frequency antenna 41 having such a shape, it is possible to create a magnetic field over a larger area than in the case of using a straight or U-shaped radio-frequency antenna.

### SIXTH EMBODIMENT

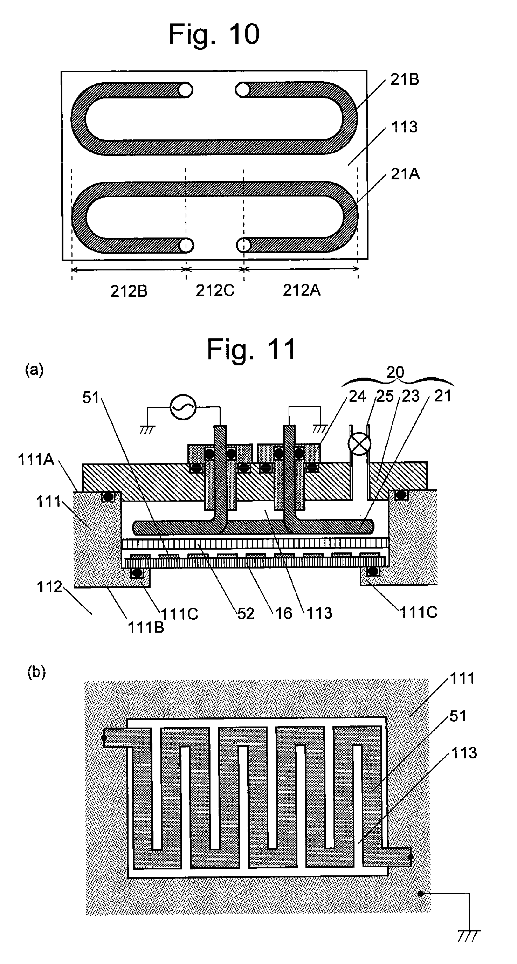

In any of the previous embodiments, there was only one radio-frequency antenna placed in each antenna-placing section (hollow space). However, it is possible to provide two or more radio-frequency antennae in one antenna-placing section. In the example shown by the top view in Fig. 10, two radio-frequency antennae 21 described in the first embodiment (first radio-frequency antenna 21A and second radio-frequency antenna 21B) are provided in the hollow space 113. The first and second radio-frequency antennae 21A and 21B are arranged so that their first and second U-shaped parts 212A and 212B are at the same distance from the separating member 16 and their connection parts 212C are parallel to each other.

### SEVENTH EMBODIMENT

A seventh embodiment of the plasma processing device according to the present invention is described by means of Fig. 11. The plasma processing device of the present embodiment is a variation of the plasma processing device 10 of the first embodiment and further includes a Faraday shield 51 placed on the separating member 16 (between the separating member 16 and the radio-frequency antenna 21). The Faraday shield 51 is electrically connected to the metallic top wall 111 and further to a ground via the top wall 111. The Faraday shield 51 stops a DC electric field produced by a self bias between the conductor of the radio-frequency antenna 21 and the plasma and thereby prevents plasma produced in the internal space 112 from impinging on the separating member 16, so that the life of the separating member 16 will be increased. A dielectric insulating member 52 is inserted between the Faraday shield 51 and the radio-frequency antenna 21 in order to prevent electric discharge from occurring in the space between the shield and the antenna.

In the Faraday shield 51, an almost entire portion of the lower surface is thermally in contact with the separating member 16, with both ends thermally connected to the top wall 111. Therefore, the heat from the separating member 16, which receives energy from the plasma and becomes hotter, is released through the Faraday shield 51 to the top wall 111. In this manner, an increase in the temperature of the separating member 16 is suppressed and the degradation of the separating member 16 due to the heat is prevented. To further improve this effect, the Faraday shield 51 may be cooled by a coolant, or a means for suppressing the temperature increase, such as a cooling pipe, may be additionally provided apart from the Faraday shield 51.

### [Other Embodiments]

The number of radio-frequency antennae 21, which was eight in the previous embodiments, can be appropriately determined according to the capacity of the vacuum container or other factors. Using only one radio-frequency antenna 21 may be sufficient for a vacuum container having a rather small capacity. Unlike the previous embodiments, in which the radio-frequency antenna unit 20 was provided in the top wall of the vacuum container, the radio-frequency antenna unit may be provided in a different wall, such as the side wall.

### EXPLANATION OF NUMERALS

- 10: Plasma Processing Device
- 11: Vacuum Container
- 111: Top Wall of Vacuum Container
- 111A: Outer Surface of Top Wall of Vacuum Container
- 111B: Inner Surface of Top Wall of Vacuum Container
- 111C: Step Formed on Top Wall of Vacuum Container
- 112: Internal Space
- 113, 113A: Hollow Space (Antenna-Placing Section)
- 113B: Antenna-Placing Section
- 12: Base-Body Holder
- 13: Gas Discharge Port
- 14: Gas Introduction Port
- 15: Base-Body Transfer Opening
- 16, 16A, 16B: Separating Member (Separating Plate)
- 20, 20A, 20B: Radio-Frequency Antenna Unit
- 21, 41: Radio-Frequency Antenna
- 211: Power Supply End
- 21A: First Radio-Frequency Antenna
- 21B: Second Radio-Frequency Antenna
- 212A: First U-Shaped Part
- 212B: Second U-Shaped Part
- 212C: Connection Part
- 23: Cover
- 24: Feedthrough
- 25, 25C: Hollow-Space Exhaust Port
- 25A: Hollow-Space Inert-Gas Introduction Port
- 25B: Hollow-Space Gas Discharge Port
- 27: Dielectric Member
- 31: Power Supply Point
- 32: Power Supply Rod
- 51: araday Shield
- 52: Insulating Member
- S: Base Body

## Claims

1. A plasma processing device, comprising:
a) a vacuum container;
b) an antenna-placing section provided between an inner surface and an outer surface of a wall of the vacuum container, the antenna-placing section being a hollow space formed between the aforementioned inner surface and the outer surface;
c) a radio-frequency antenna placed in the antenna-placing section;
d) a dielectric separating member for separating the antenna-placing section from an internal space of the vacuum container; and
e) a cover provided on a side of the antenna-placing section facing the aforementioned outer surface.

2. The plasma processing device according to claim 1, wherein the radio-frequency antenna is attached to the cover.

3. The plasma processing device, comprising:
a) a vacuum container;
b) an antenna-placing section provided between an inner surface and an outer surface of a wall of the vacuum container;
c) a radio-frequency antenna placed in the antenna-placing section; and
d) a dielectric separating member for separating the antenna-placing section from an internal space of the vacuum container.

4. The plasma processing device according to claim 3, wherein the antenna-placing section is a hollow space formed between the aforementioned inner surface and the outer surface.

5. The plasma processing device according to one of claims 1, 2 and 4, wherein the hollow space is a hermetically closed space.

6. The plasma processing device according to claim 5, wherein the hollow space is a vacuum.

7. The plasma processing device according to claim 5, wherein the hollow space is filled with an inert gas.

8. The plasma processing device according to claim 4 or 5, wherein the hollow space is filled with a solid dielectric material.

9. The plasma processing device according to claim 3, wherein at least a portion of the wall is made of a solid dielectric and the radio-frequency antenna is embedded in the solid dielectric.

10. The plasma processing device according to one of claims 1-9, wherein a plurality of the radio-frequency antennae are provided in one antenna-placing section.

11. The plasma processing device according to one of claims 1-10, wherein a grounded electrode is provided between the radio-frequency antenna and the separating member.

12. The plasma processing device according to claim 11, wherein a dielectric insulating member is inserted between the radio-frequency antenna and the grounded electrode.

13. The plasma processing device according to claim 11 or 12, wherein the grounded electrode is a Faraday shield.

14. The plasma processing device according to one of claims 11-13, wherein the grounded electrode is made to be in contact with the separating member so as to suppress an increase in a temperature of the separating member.

15. The plasma processing device according to one of claims 1-13, further comprising a mechanism for suppressing an increase in a temperature of the separating member.

16. The plasma processing device according to one of claims 1-15, wherein the separating member is made of a material selected from a group of oxides, nitrides, carbides and fluorides.

17. The plasma processing device according to claim 16, wherein the separating member is made of a material selected from a group of quartz, alumina, zirconia, yttria and silicon nitride and silicon carbide.

18. The plasma processing device according to one of claims 1-17, comprising a plurality of the antenna-placing sections.
